# FASCICULE DE BREVET EUROPEEN

(11) **EP 3 922 141 B1**
(45) Date de publication et mention de la délivrance du brevet: **14.02.2024**
(21) Numéro de dépôt: 20195959.0
(22) Date de dépôt: 14.09.2020
(51) Int. Cl.: A47F 11/10

(54) **PRÉSENTOIR DE VENTE OU DE TEST AVEC GUIDE LUMINEUX**
VERKAUFS- ODER TESTSTÄNDER MIT LICHTLEITER
DISPLAY UNIT FOR SALE OR FOR TESTING WITH LIGHT GUIDE

(30) Priorité: 11.06.2020 FR 2006125
(43) Date de publication de la demande: 15.12.2021
(73) Titulaire: Diam International SAS, 78130 Les Mureaux (FR)
(72) Inventeur: VERSEAU, Loïc, 78955 CARRIERES-SOUS-POISSY (FR); CHIARETTO, Stéphane, Loïc, 78500 SARTROUVILLE (FR); CROSVILLE, Vincent, Philippe, Pascal, 92600 ASNIERES SUR SEINE (FR)
(74) Mandataire: Lavoix

(56) Documents cités:
- WO-A1-2011/152446
- JP-A- 2016 052 575
- US-B2- 6 918 679

## Description

La présente invention concerne un présentoir de vente ou de test, à l'état monté ou en kit, comprenant, à l'état monté, un niveau inférieur destiné à recevoir des produits, un système d'éclairage adapté pour éclairer les produits par en haut, et un niveau supérieur sur lequel le système d'éclairage est fixé. De tels présentoirs permettent d'exposer des produits à vendre ou à tester.

Un système d'éclairage couramment utilisé actuellement comprend une pluralité de diodes électroluminescentes (ou LED, de l'anglais *Light Emitting Diode*), successives selon une ligne, chacune des diodes étant adaptée pour émettre une lumière blanche intense, principalement dans un angle solide formant un cône.

Ce type de système d'éclairage est adapté pour bien éclairer les produits, du point de vue de l'intensité lumineuse arrivant sur les produits. Toutefois, la zone éclairée présente des tâches ou des halos lumineux clairement identifiables par un utilisateur, créés par chacune diodes. Ces taches ou halos nuisent à l'esthétique du présentoir, ce qui dessert les produits.

Les documents JP 2016 052575 A, WO 2011/152446 et US 6 918 679 B2 décrivent des présentoirs comprenant des guides de lumière en forme de plaque.

Un but de l'invention est donc de fournir un présentoir du type décrit ci-dessus, possédant des caractéristiques techniques permettant d'améliorer la présentation des produits.

A cet effet, l'invention a pour objet un présentoir selon la revendication 1.

Selon des modes de réalisation particuliers, le présentoir comprend l'une ou plusieurs des caractéristiques correspondant aux revendications 2 à 7 et des caractéristiques suivantes
- le système d'éclairage comprend une ou deux diodes électroluminescentes situées aux extrémités du guide selon la ligne,
- l'embase ou le circuit imprimé comprend des plots adaptés pour positionner l'embase par rapport au circuit imprimé à l'état monté du présentoir,
- le circuit imprimé comprend un dissipateur thermique,
- le guide a, perpendiculairement à la ligne, une section de forme générale circulaire, avec ou sans méplat, elliptique, rectangle, carrée ou trapézoïdale,
- le plus grande dimension de la section est comprise entre 2 mm et 16 mm, par exemple entre 6 et 8 mm,
- le guide est en outre fixé sur le deuxième niveau par des clips ou des colliers de serrage, par exemple en métal ou en matière plastique,
- le guide est rigide,
- le guide est souple, et
- la ligne est curviligne ou définit un ou plusieurs angles.

L'invention sera mieux comprise à la lecture de la description qui va suivre, donnée uniquement à titre d'exemple et faite en se référant aux dessins annexés, sur lesquels :
la figure 1 est une vue schématique, en coupe verticale, d'un présentoir selon l'invention, à l'état monté,
la figure 2 est une vue schématique, en perspective, d'un système d'éclairage du présentoir représenté sur la figure 1, et d'une zone éclairée sur le niveau inférieur,
la figure 3 est une vue de dessus du système d'éclairage représenté sur les figures 1 et 2,
la figure 4 est une vue de côté d'une extrémité du système d'éclairage représenté sur les figures 1 à 3, cette extrémité comprenant une embase montée sur un circuit imprimé,
la figure 5 est une vue en perspective, de l'extrémité représentée sur la figure 4, l'embase étant à l'écart du circuit imprimé,
la figure 6 est une vue en perspective du circuit imprimé représenté sur les figures 2 à 5, le circuit imprimé étant vu du côté comprenant une diode électroluminescente,
la figure 7 est une vue de dessus d'un système d'éclairage constituant une première variante du système d'éclairage représenté sur les figures 1 à 5,
la figure 8 est une vue de dessus d'un système d'éclairage constituant une deuxième variante du système d'éclairage représenté sur les figures 1 à 5,
la figure 9 est une vue de dessus d'un système d'éclairage constituant une troisième variante du système d'éclairage représenté sur les figures 1 à 5, et
la figure 10 est une vue schématique de différentes variantes du guide, représentées en section perpendiculairement à la ligne.

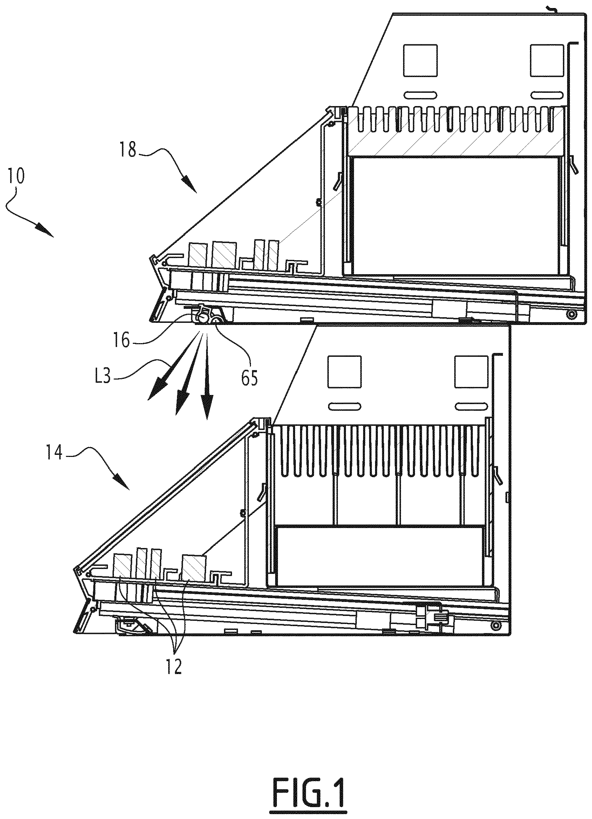

En référence à la figure 1, on décrit un présentoir 10 selon l'invention. Sur cette figure, le présentoir 10 est à l'état monté. Le présentoir 10 est destiné à présenter, à un utilisateur (non représenté), des produits 12 à vendre ou à tester.

En variante non représentée, le présentoir 10 est en kit, c'est-à-dire à l'état non monté, en pièces détachées avantageusement conditionnées dans des emballages (non représentés).

Dans l'exemple, le présentoir 10 comprend un niveau inférieur 14 recevant les produits 12, un système d'éclairage 16 adapté pour éclairer les produits par en haut, et un niveau supérieur 18 sur lequel le système d'éclairage est fixé.

Selon des variantes non représentées, le présentoir 10 peut comprendre plus de deux niveaux. Selon une de ces variantes, le niveau supérieur 18 comprend également des produits, éclairés depuis un troisième niveau situé au-dessus du niveau supérieur 18.

Par « supérieur », on entend au sens du présent texte que le niveau supérieur 16 est situé au-dessus du niveau inférieur 14 lorsque le présentoir 10 est dans une position normale d'utilisation.

Le niveau inférieur 14 forme avantageusement une étagère ou un tiroir destinés à recevoir les produits12.

Le niveau supérieur 18 est avantageusement analogue au premier niveau 14, si ce n'est qu'il sert également de support au système d'éclairage 16.

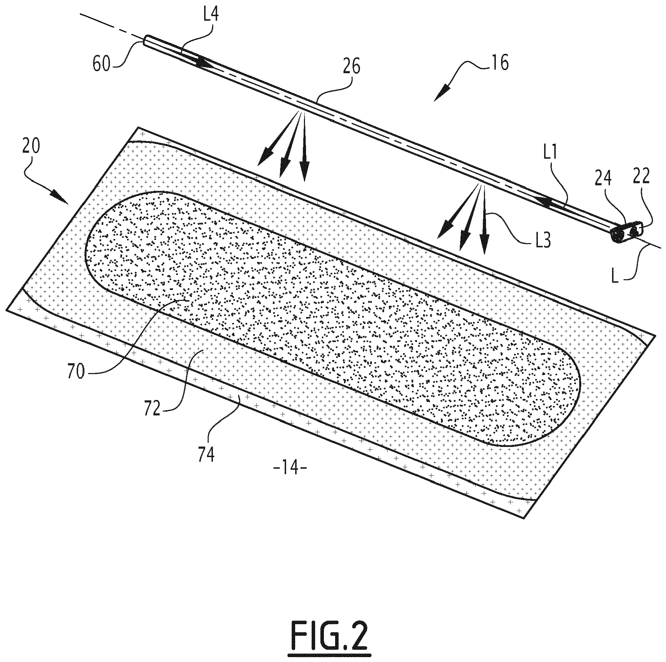

Comme visible sur la figure 2, le système d'éclairage 16 est adapté pour former une zone éclairée 20 sur le niveau inférieur 14.

Comme visible sur les figures 2 à 4, Le système d'éclairage 16 comprend un circuit imprimé 22, une embase 24, et un guide 26 en matériau translucide s'étendant à partir de l'embase selon une ligne L.

Dans l'exemple, la ligne L est droite et avantageusement horizontale dans la position normale d'utilisation du présentoir 10.

Le circuit imprimé 22 est fixé sur l'embase 24. Le circuit imprimé 22 comprend une première plaque 28 servant de support, une diode électroluminescente 30 fixée sur la première plaque, et un connecteur 32.

Avantageusement, le circuit imprimé 22 comprend aussi un dissipateur thermique 33.

La première plaque 28 comporte par exemple deux orifices 34 permettant de fixer le circuit imprimé 22 sur l'embase 24 à l'aide de deux vis, deux rivets ou deux clips (non représentés).

La première plaque 28 comporte avantageusement un bord périphérique 36 définissant une première encoche 38, par exemple située sur un grand côté 40 de la première plaque, et une deuxième encoche 42, par exemple située sur un petit côté 44.

La diode électroluminescente 30 est par exemple du type composant monté en surface (CMS).

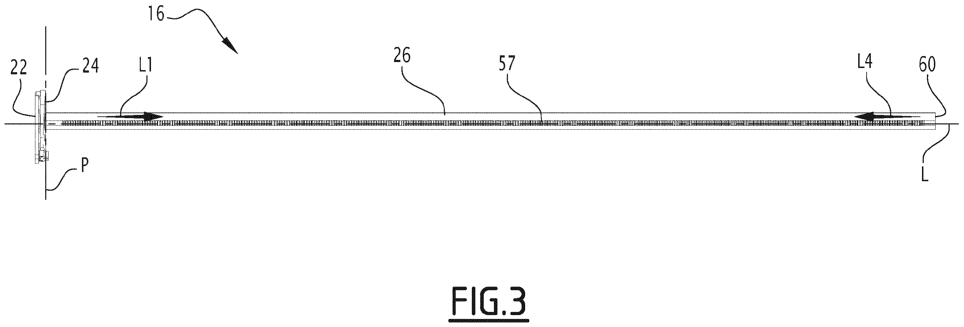

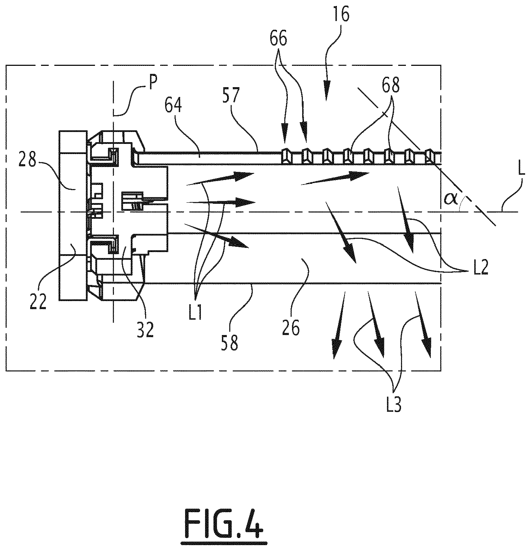

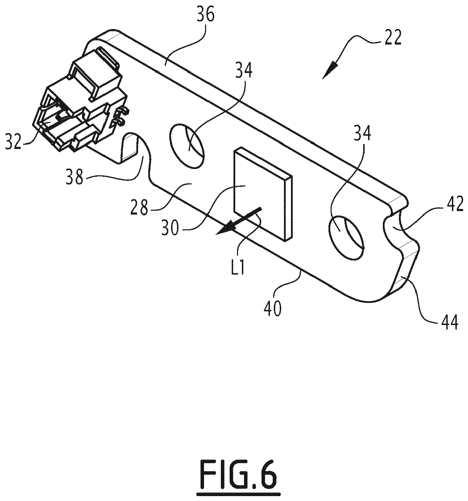

Le circuit imprimé 22 est mobile par rapport à l'embase 24 entre une position démontée (représentée sur la figure 6), dans laquelle le circuit imprimé est à l'écart de l'embase, et une position montée (représentée sur les figures 3 et 4), dans laquelle le circuit imprimé est fixé sur l'embase.

L'embase 24 comporte une deuxième plaque 46 s'étendant dans ur plan P perpendiculaire à la ligne L et parallèle à la première plaque 28 dans la position montée. L'embase 24 comprend un premier pion 48 et un deuxième pior 50 en saillie de la deuxième plaque selon la ligne L et situés de l'autre côté de la plaque par rapport au guide 26 selon la ligne L, le premier pion et le deuxième pion étant adaptés pour être reçus dans la position montée respectivement dans la première encoche 38 et la deuxième encoche 42.

L'embase 24 est par exemple réalisé dans le même matériau que le guide 26. L'embase 24 est avantageusement venue de matière avec le guide 26.

L'embase 24 comporte avantageusement une pluralité de plots 54 sur lesquels le circuit imprimé 22 vient se placer dans la position montée pour assurer un placement prédéterminé de l'embase par rapport au circuit imprimé dans la position montée.

Selon une variante non représentée, les plots 54 sont formés par le circuit imprimé 22 et coopèrent avec l'embase 24.

La deuxième plaque 46 comporte par exemple deux orifices 56 alignés avec les orifices 34 de la première plaque 28 dans la position montée, afin de permettre la fixation du circuit imprimé 22 sur l'embase 24.

Dans la position montée, le guide 26 est situé en vis-à-vis de la diode électroluminescente 30 selon la ligne L pour recueillir et conduire une lumière L1 émise par la diode électroluminescente.

Le guide 26 est configuré pour former la zone éclairée 20 sur le niveau inférieur 14 à partir de la lumière L1.

Le guide 26 est avantageusement configuré pour que la zone éclairée 20 soit exempte d'une pluralité de taches et d'une pluralité de halos distincts les uns des autres à l'oeil nu. De tels taches ou halos se formeraient si le niveau inférieur 14 était éclairé directement par une pluralité de diodes électroluminescentes.

Le guide 26 comprend un ou plusieurs matériaux de grade optique, permettant avantageusement une transmission lumineuse, telle que déterminée selon la norme ISO 13468-2 de 2006, supérieure ou égale à 80%, de préférence supérieure ou égale à 90%. La transmission lumineuse permise par le guide 26 est avantageusement au moins égale à celle du verre de vitrage.

Par exemple, le guide 26 comprend du polycarbonate, du poly(méthacrylate de méthyle) ou du verre. Selon un mode de réalisation particulier, le guide 26 est constitué de l'un de ces matériaux, l'embase 24 formant par exemple un embout venu de matière avec le guide.

Dans l'exemple, le guide 26 est rigide.

Comme visible sur la figure 4, le guide 26 comprend, dans la position normale d'usage, une surface supérieure 57 adaptée pour réfléchir vers le bas au moins en partie la lumière L1 située à l'intérieur du guide et former une lumière réfléchie L2. Le guide 26 comprend une surface inférieure 58 adaptée pour laisser passer au moins en partie la lumière réfléchie L2 et former une lumière diffusée L3 formant elle-même la zone éclairée 20.

Avantageusement, le guide 26 comprend une surface réfléchissante 60 (figure 3) située à une extrémité opposée à l'embase 24 selon la ligne L, la surface réfléchissante 60 étant adaptée pour réfléchir au moins en partie la lumière L1 située à l'intérieur du guide et former une seconde lumière réfléchie L4 se propageant en sens contraire selon la ligne L.

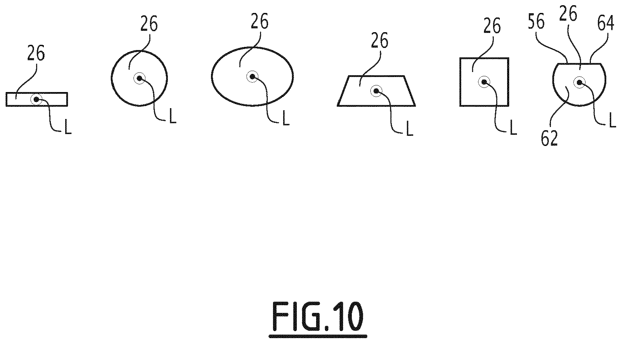

Par exemple, le guide 26 possède, perpendiculairement à la ligne L, une section 62 de forme générale circulaire, formant un méplat 64 (figures 4 et figure 10 à droite).

Le guide 26 est avantageusement solidarisé avec le niveau haut 18 grâce à un ou plusieurs clips 65 (figure 1) ou colliers de serrage, par exemple en métal ou en matière plastique.

La plus grande dimension D de la section 62 est par exemple comprise entre 2 mm et 16 mm, de préférence entre 6 mm et 8 mm.

Selon un mode de réalisation particulier, la surface supérieure 57 définit des excroissances 66 (figure 4) ou des rainures formant une pluralité de dioptres plans 68 ayant respectivement une pluralité d'inclinaisons α par rapport à la ligne L, les inclinaisons variant avantageusement l'une par rapport à l'autre le long de la ligne L. Ceci permet de régler la quantité de lumière réfléchie L2 et de lumière diffusée L3 le long de la ligne L.

Selon un mode de réalisation particulier, la surface supérieure 57 est revêtue d'une peinture réfléchissante blanche ou d'une sérigraphie réfléchissante de couleur blanche.

Les excroissances 66 ou les rainures sont par exemples orientées perpendiculairement à la ligne L.

La zone éclairée 20 est avantageusement homogène. On a représenté dans la zone éclairée 20 une partie centrale 70 oblongue intensément éclairée, entourée par une première partie périphérique 72 un peu moins éclairée, et une seconde partie périphérique 74 encore moins éclairée. La partie centrale 70 est l'unique tache de la zone éclairée 20. A l'oeil nu, un observateur ne détecte pas d'autre taches. Cet observateur ne détecte pas non plus une pluralité de halos. La zone éclairée 20 ne résulte pas de cônes de projection de lumière créés par une pluralité de diodes, mais d'une diffusion continue de lumière le long de la ligne L par le guide 26.

Pour monter le présentoir 10, on monte le niveau inférieur 14 et le niveau supérieur 18 (figure 1) de manière connue en elle-même.

Puis, on fait passer le circuit imprimé 22 de la position démontée (figure 6) à la position montée (figures 3 et 4). Le premier pion 48 est engagée dans la première encoche 38 (figure 4) et le deuxième pion 50 entre dans la deuxième encoche 42. La première plaque 28 vient au contact des plots 54. Avantageusement, les plots 54 fixent très précisément la position relative de l'embase 24 par rapport au circuit imprimé 22, et notamment par rapport à la diode électroluminescente 30, pour que le guide 26 soit parfaitement en vis-à-vis de cette dernière.

Ensuite, le circuit imprimé 22 est fixé sur l'embase 24, par exemple grâce à des rivets pression engagés dans les orifices 34 de la première plaque 28 et dans les orifices 56 de la deuxième plaque 46.

La fixation du système d'éclairage 16 est finalisée par exemple en fixant le guide 26 sur le niveau supérieur 18 grâce aux clips 65.

Le fonctionnement du présentoir 10 découle de sa structure et va maintenant être brièvement décrit.

Le présentoir 10 est à l'état monté. Les produit 12 sont éventuellement placés sur le niveau inférieur 14 et sont éclairés par le haut par le système d'éclairage 16.

D'autres produits sont éventuellement placés sur le niveau supérieur 18. Ces produits sont par exemple éclairés par un autre niveau non représenté, ou par la lumière ambiante.

En fonctionnement, la diode électroluminescente 30 émet la lumière L1 (figures 2, 3, 4 et 6) qui entre dans le guide 26.

La lumière L1 se propage ensuite dans le guide 26. La surface supérieure 57 réfléchit vers le bas au moins en partie la lumière L1 et forme la lumière réfléchie L2 (figure 4).

La surface inférieure 58 laisse passer au moins en partie la lumière réfléchie L2 et forme la lumière diffusée L3.

En tombant sur le niveau inférieur 14 ou sur les produits 12, la lumière diffusée L3 forme la zone éclairée 20.

La surface réfléchissante 60 optionnelle renvoie en sens contraire selon la ligne L la lumière L1 qui n'est pas sortie du guide 26, et forme la seconde lumière réfléchie L4. La seconde lumière réfléchie L4 est également réfléchie par la surface supérieure 57 et diffusée par la surface inférieure 58.

Grâce aux caractéristiques ci-dessus, le présentoir 10 crée une zone éclairée plus agréable pour un observateur, contrairement à ce que feraient une pluralité de diodes montées en ligne. Par ses caractéristiques techniques, le présentoir 10 améliore donc la présentation des produits 12.

Avantageusement, le présentoir 10 permet de créer une zone éclairée 20 d'aspect homogène et lisse pour l'observateur.

En outre, le présentoir 10, n'utilisant qu'une seule diode dans l'exemple ci-dessus, permet d'importantes économies d'énergie. Son impact environnemental est également réduit, car la consommation d'une seule diode électroluminescente est faible.

La caractéristique optionnelle selon laquelle la surface supérieure 57 forme les excroissances 66 permet de moduler la lumière diffusée L3 et par exemple de lui donner une intensité sensiblement constante selon la ligne L.

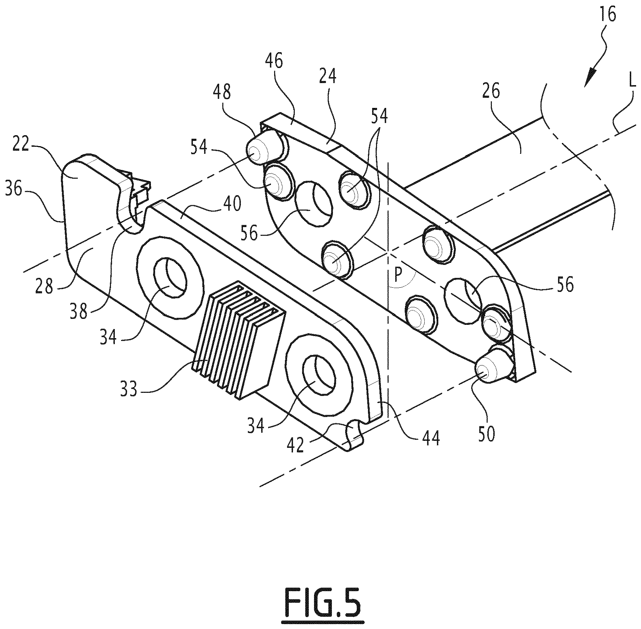

On va maintenant décrire plusieurs variantes du présentoir 10. Ces variantes restent analogues au présentoir décrit ci-dessus en référence aux figures 1 à 6. Les éléments similaires portent les mêmes références numériques et ne seront pas décrits à nouveau. Seules les différences seront décrites en détail ci-après.

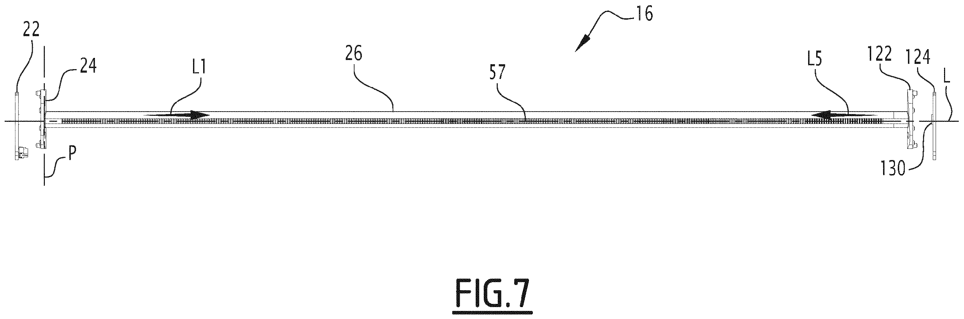

Selon une première variante représentée sur la figure 7, le présentoir 10 ne comprend pas la surface réfléchissante 60. Le présentoir 10 comprend un deuxième circuit imprimé 122 et une deuxième embase 124 situés à l'extrémité opposée du guide 26 par rapport à l'embase 24.

Le deuxième circuit imprimé 122 et la deuxième embase 124 sont avantageusement structurellement analogues au circuit imprimé 22 et à l'embase 24, et fonctionnent de manière similaire. Le deuxième circuit imprimé 122 est fixé sur la deuxième embase 124.

Le deuxième circuit imprimé 122 comprend une deuxième diode électroluminescente 130 adaptée pour émettre une deuxième lumière L5 qui entre dans le guide 26 et s'y propage en sens contraire par rapport à la lumière L1. La deuxième lumière L5 est réfléchie par la surface supérieure 57 et diffusée par la surface inférieure 58 et contribue à former la zone éclairée 20.

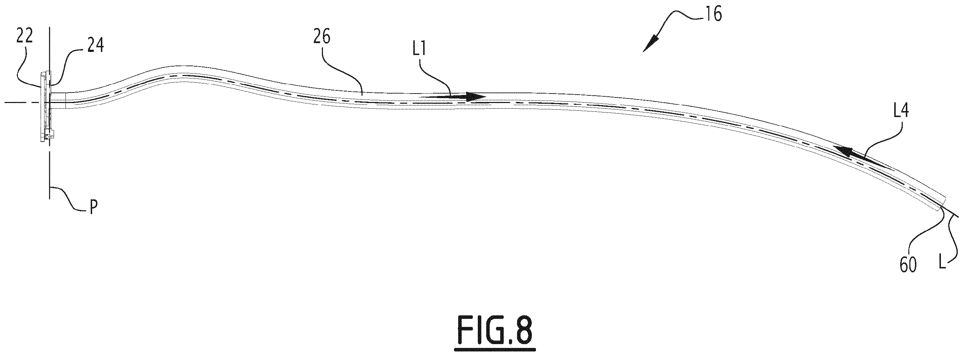

Selon une deuxième variante représentée sur la figure 8, la ligne L n'est pas rectiligne, mais curviligne. La ligne L est par exemple plane.

Selon un autre exemple, la ligne L est gauche.

Selon un mode de réalisation particulier, le guide 26 n'est pas rigide, mais souple, ce qui permet de donner une forme voulue à la ligne L et d'adapter le système d'éclairage 16 aux circonstances.

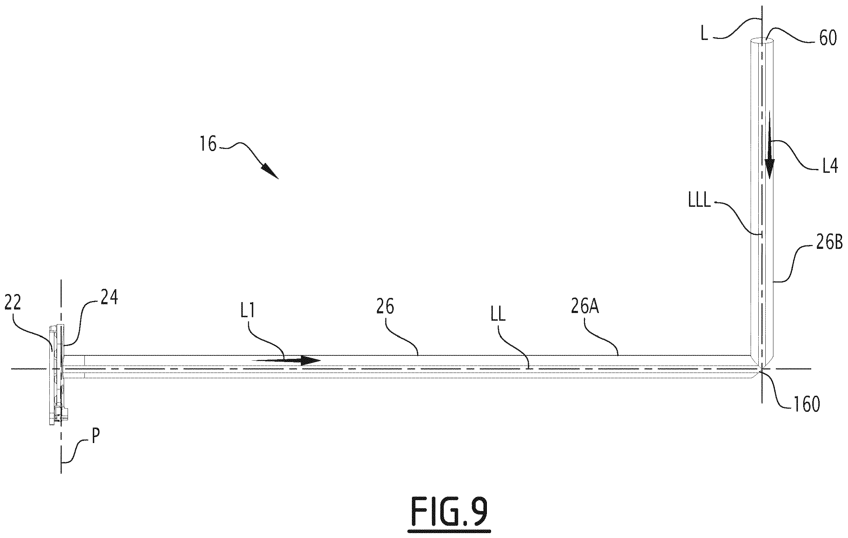

Selon une troisième variante représentée sur la figure 9, la ligne L n'est pas rectiligne, mais brisée, c'est-à-dire rectiligne par morceaux. Dans l'exemple, la ligne L comporte deux morceaux LL et LLL rectilignes, formant par exemple un angle droit entre eux.

Le guide 26 comprend deux partie 26A et 26B s'étendant selon les morceaux LL et LLL.

Entre les parties 26A et 26B, le guide 26 comporte une surface réfléchissante 160 adaptée pour que la lumière L1 arrivant depuis la partie 26A soit guidée dans la partie 26B, et avantageusement inversement que la lumière arrivant de la partie 26B soit guidée dans la partie 26A.

Selon d'autres modes de réalisation, la ligne L est brisée en plus de deux morceaux, formant entre eux plusieurs angles, par exemple quelconques.

Selon des variantes représentées sur la figure 10, la section 62 du guide 26 n'est pas de forme générale circulaire avec le méplat 64. De gauche à droite sur la figure 10, la section 62 est par exemple rectangulaire, circulaire sans méplat, elliptique, trapézoïdale ou carrée. D'autres formes sont possibles.

## Revendications

1. **,** Présentoir (10) de vente ou de test, à l'état monté ou en kit, comprenant, à l'état monté, un niveau inférieur (14) destiné à recevoir des produits (12), un système d'éclairage (16) adapté pour éclairer les produits (12) par en haut, et un niveau supérieur (18) sur lequel le système d'éclairage (16) est fixé, le système d'éclairage (16) comprenant :
- au moins une embase (24),
- au moins un circuit imprimé (22) fixé sur l'embase (24) et comportant au moins une diode électroluminescente (30) adaptée pour émettre une lumière (L1), et
- un guide (26) en matériau translucide s'étendant à partir de l'embase (24) selon une ligne (L), le guide (26) étant situé en vis-à-vis de la diode électroluminescente (30) selon la ligne (L) pour recueillir et conduire ladite lumière (L1), le guide (26) comprenant :
- une surface supérieure (5657) adaptée pour réfléchir vers le bas au moins en partie la lumière (L1) située à l'intérieur du guide (26) et former une lumière réfléchie (L2), et
- une surface inférieure (58) adaptée pour laisser passer au moins en partie la lumière réfléchie (L2) et former une lumière diffusée (L3), le guide (26) étant configuré pour former une zone éclairée (20) sur le niveau inférieur (14),
**caractérisé en ce que** le circuit imprimé (22) est mobile par rapport à l'embase (24) entre une position démontée, dans laquelle le circuit imprimé (22) est à l'écart de l'embase (24), et une position montée, dans laquelle le circuit imprimé (22) est fixé sur l'embase (24), le circuit imprimé (22) comprenant une première plaque (28) sur laquelle est fixée la diode électroluminescente (30), et l'embase (24) comporte une deuxième plaque (46) s'étendant dans un plan (P) perpendiculaire à la ligne (L) et parallèle à la première plaque (28) dans la position montée, et un premier pion (48) et un deuxième pion (50) en saillie de la deuxième plaque (46) selon la ligne (L) et situés de l'autre côté de la deuxième plaque (46) par rapport au guide (26) selon la ligne (L), le premier pion (48) et le deuxième pion (50) étant adaptés pour être reçus dans la position montée respectivement dans une première encoche (38) et une deuxième encoche (42) définies par un bord périphérique (36) de la première plaque (28).

2. **.** Présentoir (10) selon la revendication 1, dans lequel le guide (26) comprend du polycarbonate, du polyméthacrylate de méthyle ou du verre.

3. . Présentoir (10) selon l'une quelconque des revendications 1 ou 2, dans lequel la surface supérieure (56) définit des excroissances (66) ou des rainures formant une pluralité de dioptres (68) plans.

4. . Présentoir (10) selon l'une quelconque des revendications 1 à 3, dans lequel la surface supérieure (57) comporte une peinture réfléchissante de couleur blanche ou une sérigraphie réfléchissante de couleur blanche.

5. . Présentoir (10) selon l'une quelconque des revendications 1 à 4, dans lequel le guide (26) comprend une surface réfléchissante (60) située à une extrémité opposée à l'embase (24) selon la ligne (L), la surface réfléchissante (60) étant adaptée pour réfléchir au moins en partie ladite lumière (L1) située à l'intérieur du guide (26) et former une seconde lumière réfléchie (L4) se propageant en sens contraire selon la ligne (L) par rapport à ladite lumière (L1).

6. . Présentoir (10) selon l'une quelconque des revendications 1 à 5, dans lequel la ligne (L) est rectiligne.

7. . Présentoir (10) selon l'une quelconque des revendications 1 à 6, dans lequel, à l'état monté, le système d'éclairage (16) comprend :
- un second circuit imprimé (122) ayant une seconde diode électroluminescente (130), et
- une seconde embase (124) à partir de laquelle le guide (26) s'étend selon la ligne (L), le second circuit imprimé (122) étant fixé sur la seconde embase (124), et le guide (26) étant situé en vis-à-vis de la seconde diode électroluminescente (130) selon ligne (L).

## Patentansprüche

1. Ein Verkaufs- oder Testständer (10) in einem montierten Zustand oder als Bausatz, der in einem montierten Zustand eine untere Ebene (14) zur Aufnahme von Produkten (12), ein Beleuchtungssystem (16) zur Beleuchtung der Produkte (12) von oben, und eine obere Ebene (18), an der das Beleuchtungssystem (16) befestigt ist beinhaltet, wobei das Beleuchtungssystem (16) Folgendes umfasst:
- mindestens eine Basis (24),
- mindestens eine Leiterplatte (22), die an der Basis (24) befestigt ist und mindestens eine lichtemittierende Diode (30) enthält, die so beschaffen ist, dass sie Licht (L1) ausstrahlt, und
- eine Führung (26) aus lichtdurchlässigem Material, die sich von der Basis (24) entlang einer Linie (L) erstreckt, wobei die Führung (26) gegenüber der lichtemittierenden Diode (30) entlang der Linie (L) angeordnet ist, um das Licht (L1) zu sammeln und zu leiten, wobei die Führung (26) umfasst:
- eine obere Fläche (5657), die so beschaffen ist, dass sie das innerhalb der Führung (26) befindliche Licht (L1) zumindest teilweise nach unten reflektiert und ein reflektiertes Licht (L2) bildet, und
- eine untere Oberfläche (58), die so beschaffen ist, dass sie reflektiertes Licht (L2) zumindest teilweise durchlässt und gestreutes Licht (L3) bildet, wobei die Führung (26) so gestaltet ist, dass sie einen beleuchteten Bereich (20) auf der unteren Ebene (14) bildet, **dadurch gekennzeichnet, dass** die Leiterplatte (22) in Bezug auf die Basis (24) zwischen einer demontierten Position, in der die Leiterplatte (22) von der Basis (24) beabstandet ist, und einer montierten Position, in der die Leiterplatte (22) an der Basis (24) befestigt ist, beweglich ist, wobei die Leiterplatte (22) eine erste Platte (28) umfasst, an der die lichtemittierende Diode (30) befestigt ist, und die Basis (24) eine zweite Platte (46) umfasst, die in einer Ebene (P) senkrecht zu der Linie (L) und parallel zu der ersten Platte (28) in der montierten Position verläuft, und einen ersten Stift (48) und einen zweiten Stift (50), die von der zweiten Platte (46) in der montierten Position vorstehend entlang der Linie (L) und auf der anderen Seite der zweiten Platte (46) in Bezug auf die Führung (26) entlang der Linie (L) angeordnet sind, wobei der erste Stift (48) und der zweite Stift (50) so angepasst sind, dass sie in der montierten Position jeweils in einer ersten Kerbe (38) und einer zweiten Kerbe (42) aufgenommen werden, die durch eine Umfangskante (36) der ersten Platte (28) definiert sind.

2. Ständer (10) nach Anspruch 1, wobei die Führung (26) Folgendes umfasst: Polycarbonat, Polymethylmethacrylat oder Glas.

3. Ständer (10) nach einem der Ansprüche 1 oder 2, wobei die obere Fläche (56) Vorsprünge (66) oder Rillen definiert, die eine Vielzahl von ebenen Dioptern (68) bilden.

4. Ständer (10) nach einem der Ansprüche 1 bis 3, wobei die obere Fläche (57) eine weiße reflektierende Farbe oder einen weißen reflektierenden Siebdruck aufweist.

5. Ständer (10) nach einem der Ansprüche 1 bis 4, wobei die Führung (26) eine reflektierende Oberfläche (60) umfasst, die sich an einem Ende gegenüber der Basis (24) entlang der Linie (L) befindet, wobei die reflektierende Oberfläche (60) so beschaffen ist, dass sie das innerhalb der Führung (26) befindliche Licht (L1) zumindest teilweise reflektiert und ein zweites reflektiertes Licht (L4) bildet, das sich entlang der Linie (L) in Bezug auf das Licht (L1) in entgegengesetzter Richtung ausbreitet.

6. Ständer (10) nach einem der Ansprüche 1 bis 5, wobei die Linie (L) geradlinig verläuft.

7. Ständer (10) nach einem der Ansprüche 1 bis 6, wobei das Beleuchtungssystem (16) im montierten Zustand Folgendes umfasst:
- eine zweite Leiterplatte (122) mit einer zweiten Leuchtdiode (130), und
- eine zweite Basis (124), von der aus sich die Führung (26) entlang der Linie (L) erstreckt, wobei die zweite Leiterplatte (122) an der zweiten Basis (124) befestigt ist und die Führung (26) gegenüber der zweiten Leuchtdiode (130) entlang der Linie (L) angeordnet ist.

## Claims

1. A sales or test display (10), assembled or in a kit, comprising, in the assembled state, a lower level (14) intended to receive products (12), a lighting system (16) suitable for illuminating the products (12) from above, and an upper level (18) on which the lighting system (16) is fastened, the lighting system (16) comprising:
- at least one base (24),
- at least one printed circuit board (22) fastened on the base (24) and including at least one light-emitting diode (30) suitable for emitting a light (L1), and
- a guide (26) made from a translucent material extending from the base (24) along a line (L), the guide (26) being located opposite the light-emitting diode (30) along the line (L) to collect and conduct said light (L1),
the guide (26) comprising:
- an upper surface (57) suitable for downwardly reflecting at least part of the light (L1) located inside the guide (26) and forming a reflected light (L2), and
- a lower surface (58) suitable for allowing at least part of the reflected light (L2) to pass and forming a diffused light (L3), the guide (26) being configured to form an illuminated zone (20) on the lower level (14),
**characterized in that** the printed circuit (22) is movable relative to the base (24) between a disassembled position, in which the printed circuit board (22) is separated from the base (24), and an assembled position, in which the printed circuit board (22) is fastened on the base (24), the printed circuit board (22) comprising a first plate (28) on which the light-emitting diode (30) is fastened, and the base (24) comprises a second plate (46) extending in a plane (P) perpendicular to the line (L) and parallel to the first plate (28) in the assembled position, and a first pin (48) and a second pin (50) protruding from the first plate (46) along the line (L) and located on the other side of the second plate (46) relative to the guide (26) along the line (L), the first pin (48) and the second pin (50) being suitable for being received in the assembled position respectively in a first notch (38) and a second notch (42) defined by a peripheral edge (36) of the first plate (28).

2. The display (10) according to claim 1, wherein the guide (26) comprises polycarbonate, polymethyl methacrylate or glass.

3. The display (10) according to any one of claims 1 or 2, wherein the upper surface (56) defines protuberances (66) or grooves forming a plurality of flat diopters (68).

4. The display (10) according to any one of claims 1 to 3, wherein the upper surface (57) includes a white reflective paint or a white reflective serigraphy.

5. The display (10) according to any one of claims 1 to 4, wherein the guide (26) comprises a reflective surface (60) located at an end opposite the base (24) along the line (L), the reflective surface (60) being suitable for reflecting at least part of said light (L1) located inside the guide (26) and forming a second reflected light (L4) propagating in the opposite direction along the line (L) relative to said light (L1).

6. The display (10) according to any one of claims 1 to 5, wherein the line (L) is straight.

7. The display (10) according to any one of claims 1 to 6, wherein, in the assembled state, the lighting system (16) comprises:
- a second printed circuit (122) having a second light-emitting diode (130), and
- a second base (124) from which the guide (26) extends along the line (L), the second printed circuit board (122) being fastened on the second base (124), and the guide (26) being located opposite the second light-emitting diode (130) along the line (L).
